# EUROPÄISCHE PATENTSCHRIFT

(11) **EP 1 228 262 B1**
(45) Veröffentlichungstag und Bekanntmachung des Hinweises auf die Patenterteilung: **04.06.2003**
(21) Anmeldenummer: 00958162.0
(22) Anmeldetag: 25.07.2000
(51) Int. Cl.: C23C 14/00, C09C 1/00

(54) **VERFAHREN UND VORRICHTUNG ZUR ERZEUGUNG PLANPARALLELER PLÄTTCHEN**
METHOD AND DEVICE FOR PRODUCTION OF PLANE-PARALLEL WAFERS
PROCEDE ET DISPOSITIF POUR LA PRODUCTION DE PLAQUETTES A FACES PLANES ET PARALLELES

(30) Priorität: 01.10.1999 DE 19947386; 28.10.1999 DE 19952032
(43) Veröffentlichungstag der Anmeldung: 07.08.2002
(73) Patentinhaber: Weinert, Jasmin, 81925 München (DE)
(72) Erfinder: Weinert, Jasmin, 81925 München (DE)
(74) Vertreter: Winter, Brandl, Fürniss, Hübner, Röss, Kaiser, Polte, Partnerschaft
(86) Internationale Anmeldenummer: DE0002419
(87) Internationale Veröffentlichungsnummer: WO01025500

(56) Entgegenhaltungen:
- WO-A-99/65618
- US-A- 3 123 489
- PATENT ABSTRACTS OF JAPAN vol. 009, no. 322 (M-440), 18. Dezember 1985 (1985-12-18) & JP 60 155609 A (DAIDO TOKUSHUKO KK), 15. August 1985 (1985-08-15)

## Beschreibung

Die vorliegende Erfindung bezieht sich auf ein Verfahren zum Erzeugen von planparallen Plättchen und eine Vorrichtung zur Ausführung dieses Verfahren.

Planparallele Plättchen werden als Pigmente in Lacken und Druckfarben verwendet und zeichnen sich gegenüber Mahlpigmenten dadurch aus, daß sie in sehr geringer Dicke erzeugt werden können. Da sie sich nach einem Lackauftrag so orientieren, daß ihre Planflächen parallel zur Fläche des Untergrundes verlaufen, erzeugen sie im Gegensatz zu Mahlpigmenten, die mehr oder weniger diffus reflektieren, eine gerichtete Reflexion von einfallendem Licht. Die Herstellung solcher planparalleler Plättchen, deren Verwendung weit über den dekorativen Bereich hinausgeht, wird nach dem Stand der Technik im wesentlichen nach drei Verfahren durchgeführt:
a) Die Beschichtung von natürlichen Glimmerplättchen mit hochbrechenden Schichten, meistens aus TiO2, wird dadurch bewirkt, daß das Plättchen in einer titanhaltigen Lösung gerührt wird und dieses im Anschluß daran an Luft auf ca. 500 - 800°C erhitzt. Produkte unter den Markenzeichen IRIODIN® und AFFLAIR® sind Beispiele hierfür. Aus dem Stand der Technik sind ebenfalls Beschichtungsverfahren bekannt, die meist in einem 400 - 600°C heißen Fließbett stattfinden und bei denen die Reaktion TiCl4 + 2 H2O → TiO2 + 4 HCl verwendet wird. Ferner gelangen auch organische Titanverbindungen, wie Eisen- oder Kobalt-Halogenide oder Karbonyle zum Einsatz.
b) Um vom Naturstoff Glimmer unabhängig zu sein, wurden Verfahren entwickelt, wie es beispielsweise in der WO 93/08237 beschrieben ist. Hierbei wird eine dünne Schicht einer flüssigen, silikathaltigen Substanz auf ein umlaufendes Band an der Luft aufgetragen. Die Substanz wird danach auf dem Band getrocknet, reagiert in einem nachfolgenden Säurebad zu SiO2, wird anschließend in einem weiteren Wasserbad gewaschen und dann von Band abgeschabt. Die nach einem Glühvorgang entstandenen dünnen Quarzplättchen werden in einem weiteren Prozeß im Fließbett- oder Rührverfahren mit weiteren Oxiden chemisch beschichtet. Eine Zusammenstellung solcher chemischen Beschichtungen beschreiben Schmid und Mronga unter "Luster Pigments with Optically Variable Properties" ( Vortrag der European Coatings Conference, 7 - 9. April 1997, Nürnberg)
c) Um planparallele Plättchen kontrollierter Dicke zu erzeugen, wird seit Jahren das Aufdampfverfahren (PVD=physical vapour deposition) benutzt. Beispiele hierfür sind in den den Patenten U.S. 3,438,796 aus 1967 von Dupont und U.S. 5,135,812 von Flex Products aufgeführt, bei denen ein Fabry-Perot-Reflexfilter als Pigment erzeugt wird. Das Produkt zeigt eine starke Farbveränderung bei einer Winkelveränderung des Lichteinfalls und wird als Fälschungschutz auf Banknoten aufgedruckt. Bei diesen Herstellverfahren wird eine Polyesterfolie, die vorher mit einem als Trennmittel dienenden Lack, nach bekannter Methode beschichtet wurde, als Träger benutzt. Hierauf wird durch mehrfache Bedampfung des Trägers mit den verschiedenen Schichten im Vakuum das Schichtsystem aufgebracht. Die Folienrolle wird aus dem Vakuumraum entnommen und läuft auf einer weiteren Maschine durch ein Bad, in welchem die Lackschicht in einem geeigneten Lösungsmittel aufgelöst wird. Das Produkt fällt dann vom Träger als grobe Flocken ab, die durch Abtrennen des Lösungsmittels, Trocknen, Mahlen weiterverarbeitet werden. Der Folienträger ist nur einmal verwendbar und verursacht deshalb beträchtliche Kosten. Im Patent U.S. 3,123,489 von Bolomey ist die Verwendung eines Trägers, auf welchem eine große abwechselnde Schichtfolge eines Salzes als Trennmittel und Zinksulfid als Produkt aufgedampft wird, beschrieben. Der Träger ist hierbei ein umlaufendes Band oder ein Drehteller bekannter Art, wie er bei der optischen Bedampfung zum Einsatz kommt. Nach einer großen Anzahl von abwechselnden Beschichtungen mit Trennmittel und Produkt wird der Träger aus der Anlage entnommen und gewässert, wobei sich die Salzschichten zwischen den Produktschichten auflösen und das Produkt als kleine Plättchen in einer Suspension vorliegt. Dieses Material, meistens Zinksulfid, wird in der Kosmetik- und für dekorative Zwecke als künstlicher Perlglanz verwendet. Nachteilig ist trotz des einfachen Aufbaues der Vakuumanlage, daß es sich nicht um einen kontinuierlichen Prozeß handelt und daß die Aufdampfschichten, die in großer Zahl übereinander liegen, mit zunehmender Dicke säulenförmige Strukturen bilden, welche nur noch diffus reflektierend Dieser Effekt ist allerdings bei Perlglanz erwünscht, jedoch nicht bei Pigmenten, die als Lack auf AutomobilKarosserien oder als Metallglanz-Druckpigmente verwendet werden.

Eine zum Zeitpunkt dieser Anmeldung noch nicht offengelegte deutsche Patentanmeldung bezieht sich auf die Verwendung eines umlaufenden Metallbandes, auf das nacheinander das Trennmittel und die Schichtenfolge der zu erzeugenden planparallelen Plättchen im Hochvakuum aufgedampft werden. Danach durchläuft das Metallband einen weiteren Vakuumraum höheren Druckes, in welchem in einer Flüssigkeit, die normalerweise Wasser mit einer Temperatur von 35° ist, das Trennmittel aufgelöst wird. Die Verwendung von vielen Schleusen, die das Metallband aus dem Hochvakuum auf Atmosphärendruck ausfahren würde, wird dadurch vermieden. Wasser von 35°C hat nur einen Dampfdruck von 54 mbar. Weitere Schleusen, die zwischen 54 und 1000 mbar eingesetzt werden, entfallen. Der Prozeß findet vollständig unter Vakuum zwischen etwa 10-4 und 54 mbar statt. Nur das Produkt wird als Suspension auf Atmosphärendruck ausgebracht. Trotz dieser fortschrittlichen Technik wird immer noch ein Bandmaterial benötigt, welches an Umlenkrollen durch Biegungen mechanisch belastet wird. Die Dauerstandsfestigkeit des Bandes ist nach einer gewissen Anzahl von Zyklen überschritten, so daß es gewechselt werden muß.

Die gleichzeitige Einwirkung einer Salzlösung vermindert die Dauerstandsfestigkeit weiter, typischerweise um den Faktor 2-3 (Thyssen Edelstahl Techn. Ber. 7/1981, Band 1, S. 68-69), so daß in gewissen Zeitabständen ein Wechseln des Metallbandes erforderlich ist. Die Verwendung von Hochglanz-Trägeroberflächen mit sehr geringer Rauhtiefe, wie Glas, Quarz, glasierte Keramik oder emaillierter Stahl ist bei einem über notwendige Umlenkrollen laufenden Band nicht möglich.

Das Dokument WO 99/65618 beziehtsich auf die Herstellung von dünnen Filmteilchen mittels Alokratzen von einer Trommel.

Aufgabe der vorliegenden Erfindung ist es, ein Verfahren zu schaffen, bei dem unabhängig von der Art des verwendeten Trägermaterials die Erzeugung planparalleler Plättchen in effektiver Weise ausgeführt wird. Während des gesamten Herstellungsprozesses sollen dabei die aufgedampften Schichten keine weiteren Oberflächen berühren bis die Ablösung des Produktes vom Träger stattfindet. Genauer gesagt sollen Schichten, insbesondere solche für Infrarot-Anwendungen und für Mikrowellen-Absorber, die aus bis zu 35 Einzel schichten bestehen können, nicht vorzeitig durch Biegung an Umlenkrollen vom Träger abplatzen.

Diese Aufgabe wird durch ein Verfahren nach Anspruch 1 und eine. Vorrichtung nach Anspruch 10 gelöst.

Durch das Vorsehen von sowohl einer Beschichtungseinrichtung als auch einer Ablöseeinrichtung an einem um eine Achse drehbaren Träger, dessen Flächenabschnitt zwischen diesen beiden Einrichtungen durch Rotation des Trägers transportierbar ist, kann eine Produktschicht kontinuierlich aufgebracht und entfernt werden und somit effektiv und mit geringem Abfall die Erzeugung von planparallelen Plättchen ausgeführt werden.

Vor der Produktschicht wird eine Trennmittelschicht aufgebracht, wodurch ein einfaches Ablösen der Produktschicht durch Auflösung des Trennmittels ermöglicht wird.

Die Produktschicht kann auch mehrschichtig ausgeführt sein, wodurch sich Mehrschichtplättchen mit komplexeren Eigenschaften erzeugen lassen. Dabei kann die Produktschicht während eines Umlaufs oder mehrerer Umläufe des Trägers aufgebracht werden. Dieses gestattet eine variable Anpassung der Bedingungen an die unterschiedlichen Eigenschaften von Produktschichten.

Durch zumindest zwei Umdrehungen des Trägers vor dem Ablösen der Mehrfachschichten als Paket wird die Flüssigkeit in der Ablöseeinrichtung abgelassen, damit keine Ablösung erfolgt, bevor das Schichtenpaket komplett ist.

Das Trennmittel wird bei einem Vakuum verdampft, welches eine ausreichend große Mittlere Freie Weglänge für die Moleküle des Trennmittels schafft. Den geometrischen Verhältnissen einer Beschichtungsanlage angepaßt soll die Mittlere Freie Weglänge bei etwa 10 bis 50 cm liegen. Dieses entspricht einem notwendigen Vakuum im Verdampfungsraum von etwa 1x10⁻⁴ bis 5x10⁻⁴ mbar.

Es kann ein beliebiges Trennmittel verwendet werden, wobei anorganische Trennmittel eine bessere Eignung aufweisen, besonders dann, wenn Schichten von großer Dicke mit > 5 µ oder Schichten bei sehr hohen Temperaturen aufgedampft werden. Die hohe thermische Belastung des Trägers schließt dann die Verwendung organischer Trennmittel aus. Beispiele für Verdampfungssubstanzen sind Chrom, Titan, Nickel, Oxide des Aluminiums, des Titans und des Siliziums.

Bei der Verwendung eines organischen Trennmittels ist es von Vorteil, wenn zur Ablösung der Produktschicht der Träger in den organischen Stoff eintaucht und dort die Trennmittelschicht aufgeschmolzen wird.

Von Vorteil ist es ebenfalls, wenn sich verschiedene Flächenabschnitte zum gleichen Zeitpunkt unter den verschiedenen Einrichtungen befinden, so daß bei der Beschichtung des einen Flächenabschnitts die Produktschicht von einem anderen Flächenabschnitt gleichzeitig entfernt wird. Ein effektiver Betrieb einer solchen Vorrichtung wird auf diese Weise ermöglicht.

Durch den Einsatz von Beschichtungsverfahren unter Vakuum lassen sich ein effektiver Prozeßverlauf und eine hohe Qualität der Plättchen erzielen. Dabei ist die Abschottung zwischen Bereichen mit unterschiedlichem Druck von Bedeutung. Als Beschichtungsverfahren unter Vakuum können beispielsweise das Aufdampfverfahren, das Sputtern, die Plasmapolymerisation oder eine Kombination dieser Verfahren in derselben Vakuumkammer zum Einsatz gelangen.

Als Träger lassen sich eine Vielzahl von rotationssymmetrischen Körpern einsetzen, wodurch eine Anpassung an die vom Besteller gewünschten Eigenschaften der Plättchen mit geringem Aufwand möglich ist.

Eine beidseitige Beschichtung des Trägers oder/und eine parallele Beschichtung mehrerer Träger trägt ebenfalls zur Erhöhung der Plättchenausbeute bei.

Erfindungsgemäße Weiterbildungen sind Gegenstand der Unteransprüche.

Nachfolgend wird die Erfindung anhand der beiliegenden Zeichnungen erläutert, in denen
Fig. 1 und Fig. 2 eine Vorder- bzw. Seitenansicht der erfindungsgemäßen Vorrichtung zeigen,
Fig. 3 eine erste Abwandlung der erfindungsgemäßen Vorrichtung zeigt,
Fig. 4 eine zweite Abwandlung der erfindungsgemäßen Vorrichtung zeigt,
Fig. 5 eine dritte Abwandlung der erfindungsgemäßen Vorrichtung zeigt, und
Fig. 6 die Funktionsweise des Ablöseschritts veranschaulicht.

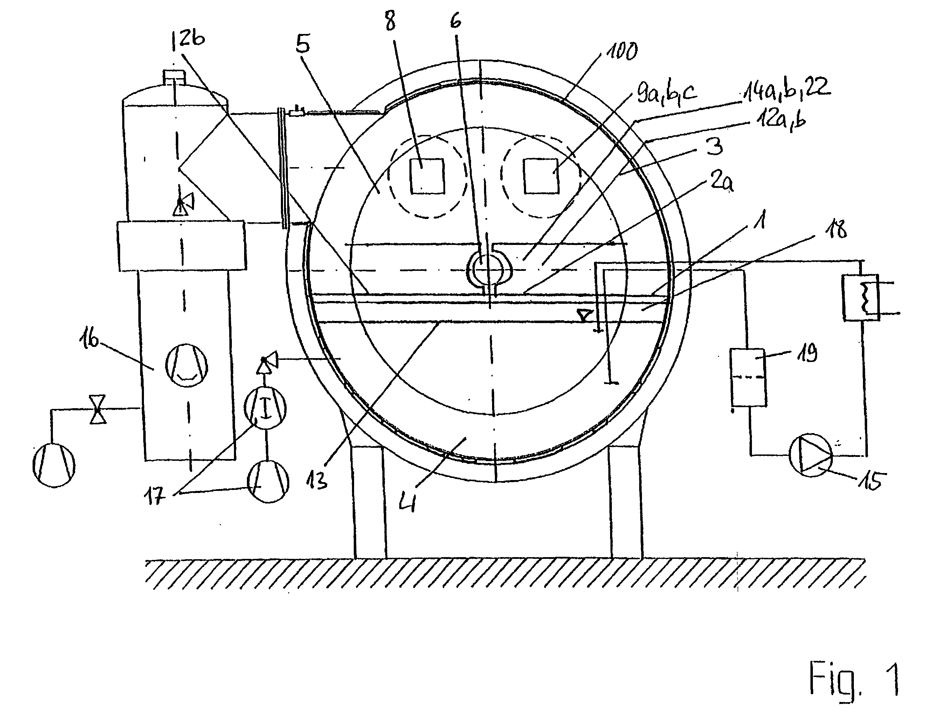

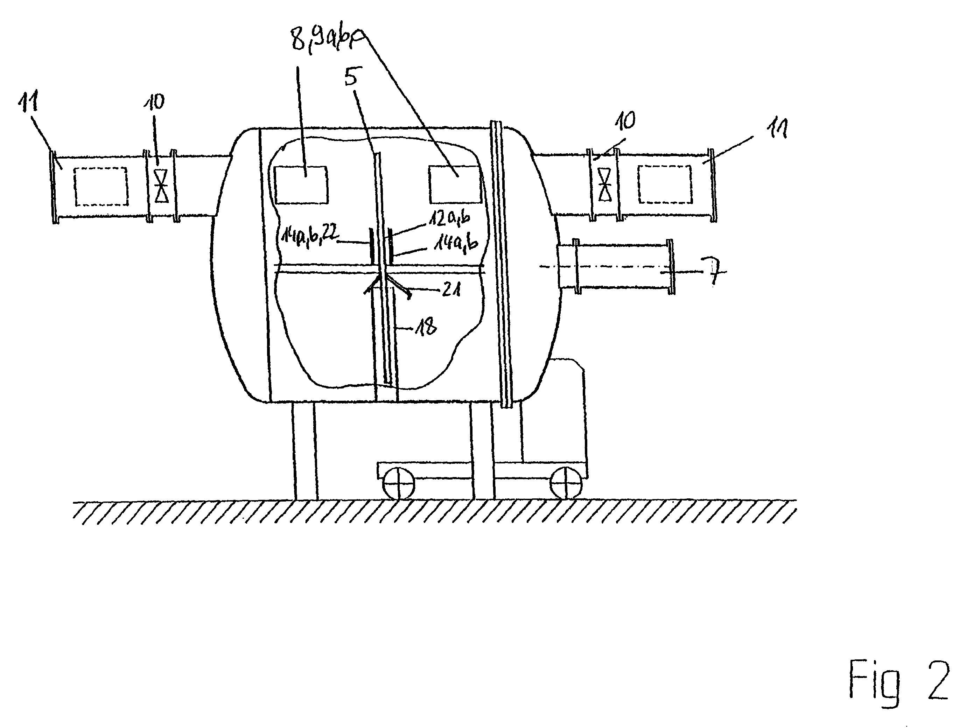

Zur Erzeugung von erfindungsgemäßen planparallelen Plättchen aus Metallen, Oxiden, Fluoriden, Nitriden und Karbiden und anderen im Vakuum auftragbaren Stoffen in beliebigen Kombinationen besteht das Gerät im wesentlichen aus den folgenden, in den Fig. 1 und 2 gezeigten Elementen:

Einer Vakuumkammer 100, die eine Zwischenabschottung 1 mit zwei Verbindungsöffnungen 2a und 2b aufweist, welche die Vakuumkammer 100 in einen Verdampfungsteil 3 und einen Produktsammelteil 4 trennt.

Einem rotierenden, starren Träger 5 aus Metall, Glas oder emaillierten Stahl oder einem anderen Stoff, der eine möglichst glatte Oberfläche aufweist und der sich bei den vorherrschenden Vakuumbedingungen im Vakuum durch Bedampfen, Sputtern oder mittels eines PECVD-Prozesses beschichten läßt. Der Träger 5 ist zentrisch auf einer rotierenden Welle 6 angeordnet, die von einem außerhalb des Vakuumraumes befindlichen Antrieb 7 in Drehbewegung gesetzt wird. Jeder Sektor des rotierenden, starren Trägers 5 wird bei der Rotation am Verdampfer 8 des Trennmittels, an dem oder den Verdampfern 9a, 9b, 9c, die die Schichtenfolge des Produktes bestimmen, vorbeigeführt.

Die Verdampfer 9a,9b,9c werden nach bekannter Bauart so ausgelegt, daß Verdampfungsmaterial, welches in Drahtform, in Blechform oder als Granulat vorliegt, kontinuierlich zugeführt wird. Die Verdampfer 9a,9b,9c können zur Wartung aus der Arbeitszone in einen weiteren Vakuumraum 11, der durch eine Schleuse 10 bekannter Bauart abgesperrt werden kann, zurückgezogen werden und kühlen unter Vakuum ab.

Als im Vakuum verdampfbare Trennmittel eignen sich nach bekannter Art Chloride, Borate, Fluoride, Hydroxide und andere weitere anorganische Substanzen. Einige werden in den Patenten U.S. 5,156,720 von Rosenfeld und Smits und in U.S. 3,123,489 von Bolomey beschrieben.

Zur Erzielung gleicher Schichtdicken erfolgt die Messung jeder einzelnen Schicht durch optische Messung des reflektierten Lichtes, sofern die Schichten transparent sind. Auf einer metallischen Unterlage zeigen transparente Schichten in Abhängigkeit von ihrer Schichtdicke n x d (n: Brechungsindex des Schichtmaterials, d: geometrische Dicke) verschiedene Interferenzfarben. Diese Farben können für die Regelung der gewünschten Schichtdicke durch spektrale Messung des reflektierten Lichtes verwendet werden. Daneben existiert nach DE 4338907 ein Verfahren, welches mittels einer Laser Dickenmessung an einem den Dampfstrahl durchwandernden Draht dessen Dickenzunahme durch Metallkondensat mißt und auf die Schichtdicke, die auf dem Träger aufgebracht wurde, kontinuierlich umrechnet.

Nach Passieren der Verdampfer- oder Sputterzonen durchläuft der rotierende, starre Träger 5 einen engen Kanal 12a und 12b in der Zwischenabschottung 1. Die Kanäle 12a und 12b sind so beschaffen, daß seine Wände zum rotierenden, starren Träger einen konstanten Abstand, typisch von 0.5-1mm aufrechterhalten. Derartige Abstandsregelungen sind Stand der Technik und sorgen für einen geringen Gasstrom zum Verdampfungsteil 3. Nach dem Durchlaufen des Kanals 12a taucht der beschichtete Teil des Trägers 5 in ein unterhalb der Zwischenabschottung 1 angeordnetes Bad 13 ein, in welchem sich eine Flüssigkeit befindet, die a) einen niedrigen Dampfdruck aufweist und b) ein gutes Lösemittel für das aufgedampfte Trennmittel darstellt.

Solche Flüssigkeiten sind: Sekundäre und tertiäre Alkohole wie Ethylenglykol, Propylenglykol, Glyzerin und deren Derivate, aber auch höhere primäre Alkohole und deren Derivate. Diese Flüssigkeiten haben im technisch interessanten Temperaturbereich von 20-50°C einen Sättigungsdampfdruck von 0.01 bis 0.05 mbar, während im Verdampfungsteil 3 ein Vakuum von typisch 3x10-4 mbar erzeugt wird. Der Gasdurchsatz durch die Verbindungsöffnungen 2a und 2b allein in der Zwischenabschottung 1 wäre zu hoch, um bei vertretbarem Pumpaufwand eine Druckdifferenz an der Zwischenabschottung 1 von 0.05 mbar aufrechtzuerhalten. Der Gasdurchsatz durch dünne Spaltrohre 14a, 14b vermindert sich nach Wutz, Theorie und Praxis der Vakuumtechnik, ISBN 3-528-04884-0, Seite 101, G1. 4.95 um den Faktor 25,3 , wenn an Stelle einer Verbindungsöffnung von 0,2 cm Weg ein Spaltrohr von 20 cm Länge zwischen dem Produktsammelteil 4 und dem Verdampfungsteil 3 verwendet wird. Durch Ersetzen der Spaltöffnungen in der Zwischenabschottung durch dort angebaute Spaltrohre, die Kanäle 12a, 12b von je 2 x 0.05 cm freilassen und durch eigenes, kontinuierliches Abpumpen dieser Kanäle auf 10-2 mbar vermindert sich der gesamte Gasfluß für zwei Kanäle von 250 cm Breite und je 2 x 0.05 cm Dicke bei einer Kanallänge von 20 cm Kanäle auf 0.11 mbar lit/sec. Dieser Gasstrom belastet die Hochvakuumpumpen 16 nur gering. Das Produktsammeiteil 4 und die Kanäle 12a, 12b werden durch mechanische Pumpen 17, bestehend aus je einer Kombination aus mechanischen Vakuumpumpen und Drehkolbengebläsen gepumpt. Die Dimensionierung aller Vakuumpumpen ist abhängig von der gewählten Größe der Vakuumkammer 100 und den Arbeitsbedingungen. Die technische Literatur kennt hierzu zahlreiche Auslegungsverfahren.

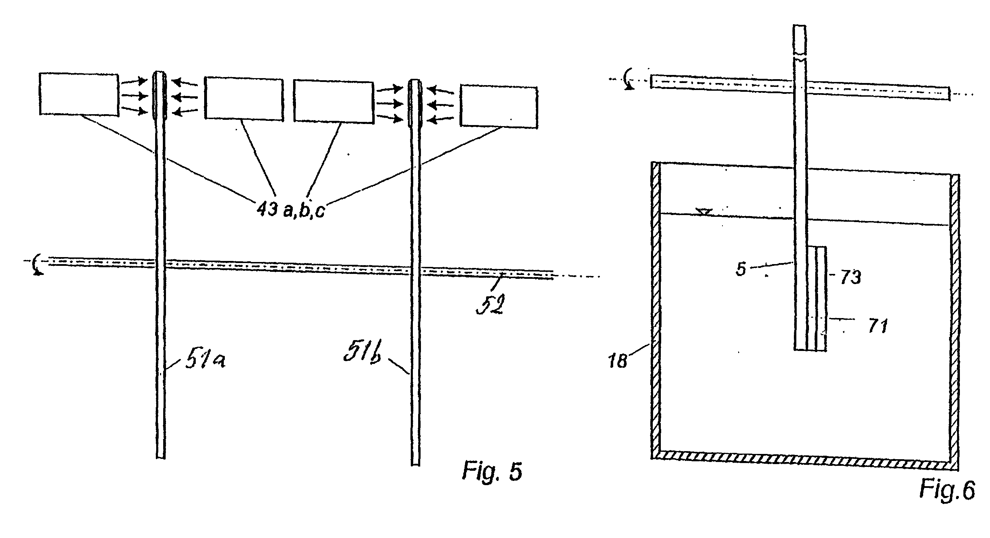

Entsprechend Fig. 6 wird im Gefäß 18 im weiteren Verlauf der mit Trennmittel und den Produktschichten bedampfte rotierende, starre Träger 5 durch mechanische Unterstützung nach bekannten Methoden unterhalb des Flüssigkeitspegels die Trennmittelschicht 71 aufgelöst. Die Produktschichten 73, die nicht löslich sind, fallen dabei als kleine flockenartige Partikel vom Träger 72 ab. In nachfolgenden Prozessen erfolgt später die Zerkleinerung auf die gewünschten Abmessungen der planparallelen Plättchen. Hierzu stehen bekannte Zerkleinerungs- und Sortierprozesse, wie Mahlen und Windsichten bei Atmosphärendruck zur Verfügung. Als letzter Schritt erfolgt die Weiterverarbeitung zu Lacken oder Druckfarben.

Nach erfolgter Ablösung des Schichtensystems wird die Suspension nach Fig. 1 durch eine Flüssigkeitspumpe 15 aus dem Gefäß 18 an die Atmosphäre gefördert. Die Suspension durchströmt dabei eine Filteranordnung 19 oder eine Zentrifugenanordnung bekannter Bauart, die sich außerhalb der Vakuumkammer 100 befinden. Von dort kehrt die von Partikeln befreite Flüssigkeit, nachdem sie vorher in einem Erhitzer 20 wieder auf die Arbeitstemperatur des Gefäßes 18 gebracht worden ist, wieder in das Gefäß 18 zurück.

Im weiteren Verlauf taucht der Träger 5 aus der Flüssigkeit im Gefäß 18 aus. Restliche Flüssigkeitsspuren werden durch einen Schaber 21 grob entfernt und laufen in das Gefäß 18 zurück. Ein dann noch verbleibender Film verdampft gegen eine Tieftemperatur-Oberfläche 22 und kondensiert dort. Nach dem Durchlaufen eines Spaltrohres 14b befindet sich der entsprechende Sektor des rotierenden, starren Trägers 5 wieder im Verdampfungssteil 3. Der Kreis ist geschlossen.

Eine Anlage zur Erzeugung von plättchen-förmigen Pigmenten im PVD-Prozeß erfordert bei der hier beschriebenen Anordnung Verdampfer 9a,9b,9c, welche in der Lage sind, in horizontaler Richtung im Langzeitbetrieb abzudampfen. Solche Verdampfer sind in der Schrift DE 4342574 (Weinert) beschrieben. Weitere Verdampferversionen, die in horizontaler Richtung verdampfen, sind im Patent U.S. 2,665,226 (Godley) beschrieben.

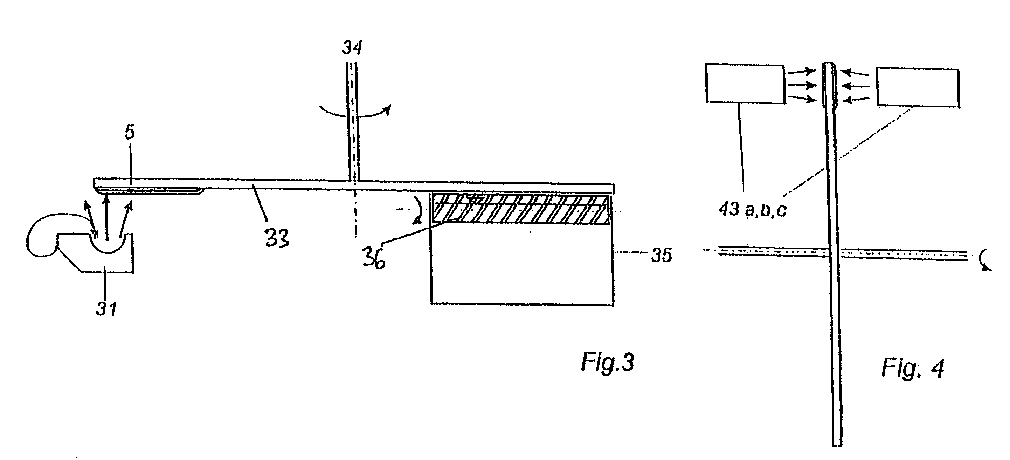

Die vorliegende Erfindung bezieht sich nicht nur auf die beschriebene Anordnung aus den Fig. 1 und 2, sondern erlaubt die folgenden Ausführungsbeispiele der Fig. 3 bis 6, sowie weitere, die sich für den Fachmann ohne weiteres aus der vorliegenden Offenbarung erschließen.

An Stelle der Erzeugung von glatten, ebenen Plättchen können planparallele Plättchen auch eine Struktur der Oberfläche aufweisen, da Vakuumbeschichtungsverfahren im Mikro-Bereich keine Dickenunterschiede erzeugen. Es ist daher möglich, durch vorheriges Ätzen nach dem Photo-Resistverfahren gewünschte Oberflächenmuster auf dem Träger zu erzeugen. Dadurch können statt ebenerer Plättchen Miniatur-Reflektoren, die einfallendes Licht durch ihre sphärische Form nur wenige Millimeter vor ihrer Oberfläche fokussieren, erzeugt werden. Es lassen sich aber auch Plättchen mit optischen Gitterlinien oder mit scharfkantigen, erhabenen Stegen, die als Sollbruchstellen zur Erzeugung von Plättchen definierter Form und Größe dienen, erzeugen. Bei der Kondensation aus der Dampfphase entsteht auf dem Träger ein Abdruck seiner Struktur. Derartige Muster sollen im Bereich der später verwendeten Teilchengröße von etwa 520 Mikrometer liegen. Voraussetzung ist jedoch, daß solche Schichten vom Träger 5 bei jeder Umdrehung abgelöst werden, damit diese ihre Feinstruktur nicht verlieren. Dieses Vorgehen ist bei bekannten Verfahren, die entweder ein umlaufendes Metallband oder die Aufdampfung einer großen Zahl von abwechselnden Trennmittel- und Produktschichten benutzen, nicht umsetzbar.

Um Elektronenstrahl- Verdampfer 31 einsetzen zu können, die aus einer Badoberfläche 32 heraus nur in senkrechter Richtung nach oben verdampfen, ist es nach Fig. 3 notwendig, den Träger 33 um eine vertikale Achse 34 zu rotieren. Ebenso ist das Gefäß 35 entsprechend anzupassen. Der Träger taucht hier nicht in das Gefäß 35 ein. Stattdessen werden die Schichten durch bürstenförmige, rotierende Elemente 36 entfernt.

Es ist nach Fig. 4 möglich, am rotierenden Träger 42 beidseitig Verdampfer 43a,43b,43c anzubringen.

Ebenso ist es nach Fig. 5 möglich, mehrere Träger 51a, 51b, die in diesem Fall Scheiben sind, gleichzeitig auf derselben Achse 52 zu betreiben , wobei sich die Zahl der einzusetzenden Verdampfer auf je einen Verdampfer für jede zu beschichtende Trägeroberfläche vervielfacht.

An Stelle einer oder mehrerer scheibenförmigen Träger oder eines oder mehrerer rotierender Ringe, die konzentrisch angeordnet sind, können Zylinder mit horizontaler Achse verwendet werden. Beliebige weitere rotationssymmetrische Körper sind als Träger einsetzbar.

Um planparallele Plättchen einer großen Zahl von sich wiederholenden Schichten des Typs (A,B)N oder (A,B,C)N herzustellen, wobei N die Zahl der Wiederholungen der Schichtkombination und A,B,C die verdampften Substanzen sind, bietet sich ohne Änderung der Apparatur folgende Möglichkeit:
a) Das Trennmittel wird im ersten Schritt allein auf den Träger aufgedampft, indem alle anderen Verdampfer durch eine verschließbare Blende abgesperrt worden sind und die Flüssigkeit im Gefäß 18 nach Fig. 1 mit dem Träger nicht in Berührung gelangt. Dies geschieht durch Absenken des Pegels im Gefäß 18.
b) Die Schichten A und B oder A,B,C werden aus zwei oder drei Verdampfern, die auf dem Rotationsweg des Trägers 5 angeordnet sind, mit kontrollierter Schichtdicke aufgebracht. Nach N Rotationen liegt N-mal der Schichtverbund A,B oder A,B,C vor. Der Trennmittelverdampfer ist hierbei durch eine Blende abgesperrt.
c) Die Verdampfer, die die Schichten A,B oder A,B,C erzeugt haben, werden durch Blenden abgesperrt. Der Flüssigkeitspegel im Gefäß 18 wird bei fortgesetzter Rotation des Trägers 5 soweit gehoben, daß die aufgedampften Schichten berührt werden. Durch die in den Schichten vorliegenden Mikrorisse, die durch Eigenspannungen in den Schichten von selbst entstehen, erreicht auch bei einer sehr großen Anzahl von Schichten die Flüssigkeit das Trennmittel, löst dieses auf, wobei sich die Produktschichten flockenartig ablösen und dann als Suspension vorliegen. Die hierzu notwendige Zeit ist zwar länger als bei Produkten mit einer geringen Zahl von Einzelschichten, sie liegt jedoch bei weniger als 30 Sekunden.
d) Der Prozeß wird analog zu a) wiederholt.

Solche Schichtsysteme sind aus der Erzeugung sogenannter Kaltlichtspiegel und infrarot-reflektierenden Oberflächen bekannt, die abwechselnd bis zu 31 Schichten aus je einem transparenten Material mit hohem Brechungsindex und niedrigem Brechungsindex benötigen. In diesem Fall ist das Schichtsystem selbst das Produkt, welches als kleine Plättchen mit den gewünschten optischen Eigenschaften vorliegt, ohne daß ein Träger, etwa eine Glasplatte oder ein gläserner Reflektor, verwendet werden muß. Von weiterem Vorteil ist, daß derartige Plättchen auch mit strukturierten Oberflächen, wie konkave oder konvexe Mikroreflektoren, herstellbar sind und im Gegensatz zu Schichten, die auf einer Glasunterlage abgeschieden werden, in einem breiten Infrarotbereich transparent bleiben. Die Anordnung der Schichtdicken erfolgt nach bekannten Prinzipien der Optik dünner Schichten. Bei Verwendung von Titanoxid und Magnesiumfluorid, aber auch bei Kombinationen anderer Materialien, wie Tantaloxid, Zirkonoxid, Ceroxid, Zinksulfid und anderen bekannten Stoffen für die hochbrechenden Schichten und Quarz oder andere Fluoride als niedrigbrechende Schicht, ergibt sich ein Plättchenmaterial, welches im Bereich von 400 bis 10.000 Nanometer weitgehend absorptionsfrei ist.

Nachfolgend werden Beispiele für den Prozeßablauf zur Erzeugung von planparallelen Plättchen aus Aluminium angeführt.

### Beispiel I:

Eine Vakuumkammer nach Fig. 1 und Fig. 2 enthält 2 Verdampfer, welche auf einem Kreisbogen in Drehrichtung des Trägers angeordnet sind. Der erste Verdampfer ist mit Natrium-tetraborat, welches zuvor an der Atmosphäre durch Glühen auf 600°C von Kristallwasser befreit worden ist, gefüllt und wird bei einem Kammervakuum von 2 x 10-4 mbar auf eine Temperatur von ungefähr 1300°C aufgeheizt, während sich der Träger bereits in Rotation um seine horizontale Achse befindet. Zeitversetzt wird der zweite Verdampfer für Aluminium auf etwa 1500°C aufgeheizt und Aluminium in Drahtform nach bekannter Art zugeführt. Um die gewünschte horizontale Abdampfrichtung zum Träger hin zu erreichen, befindet sich um den Aluminium-Verdampfer herum ein U-förmigen beheiztes Schild, welche den Metalldampf vorzugsweise in Richtung auf den Träger lenkt. Beide Verdampfer werden kontinuierlich betrieben bis ihr Vorrat an Verdampfermaterial erschöpft ist. Währenddessen transportiert der rotierende Träger die auf ihm aufliegenden Schichten durch einen Spaltrohr-förmigen Kanal in einen Raum höheren Druckes von typisch 0.04 mbar, wo der beschichtete Teil des Trägers in die Flüssigkeit in ein Gefäß eintaucht, in welchem, durch Unterstützung von Ultraschall, der den Träger in der Flüssigkeit bestrahlt, die Aluminiumschicht aufgerissen wird. Das einwirkende Glyzerin, welches bei seiner Betriebstemperatur von 50°C einen Dampfdruck von weniger als 0.04 mbar aufweist, löst die Trennmittelschicht aus Natriumtetraborat schnell auf.

Das Alumininium liegt nun als Plättchen in der Flüssigkeit vor. Während der rotierende Träger ständig neue Schichten aus Natriumtetraborat und Aluminium nachliefert, wird die Suspension von einer Flüssigkeitspumpe aus dem Gefäß laufend abgesaugt, auf einen Druck von etwa 1.5-6 bar gebracht und an der Atmosphäre in eine Mantelzentrifuge geführt. Durch den Dichteunterschied legen sich die Aluminiumplättchen an dessen Wand, die klare Flüssigkeit wird aus dem Mantel ausgetragen und fließt über ein Ventil wieder in das unter Vakuum befindliche Gefäß ohne Luft anzusaugen zurück. Ein Wärmetauscher in diesem Glyzerinkreis sorgt dafür, daß die Temperatur konstant gehalten werden kann. Der rotierende, nun von Schichten befreite Träger taucht aus der Flüssigkeit auf, durchläuft zuerst mehrere mechanische Abstreifer und verläuft dann zwischen zwei in sehr geringer Entfernung von seiner Oberfläche befindlichen, auf -30°C gekühlten Platten. Durch das Partialdruckgefälle verdampft das noch als Film von weniger als 1 Mikrometer am Träger anhaftende Glyzerin und kondensiert auf der kalten Fläche, von der es abläuft. Auf seinem weiteren Weg durchquert der Träger einen zweiten Spaltrohr-förmigen Kanal und gelangt wieder in den Bereich des Trennmittelverdampfers mit Natriumtetraborat. Der rotierende Träger besteht hier aus einer hochglanzpolierten Blechscheibe aus 3 mm rostfreien Stahl, deren Durchmesser etwas kleiner als der Durchmesser der Vakuumkammer ist. Im Beispiel wird eine Vakuumkammer von 2 Meter Durchmesser und eine Scheibengröße von 1.9 Meter verwendet. Verdampfer für Trennmittel und Aluminium sind zu beiden Seiten der Scheibe angebaut. Der bedampfte Kreisring auf der Scheibe besitzt eine Breite von 0.60 Metern und rotiert mit einer Geschwindigkeit von 10 Umdrehungen pro Minute. Pro Minute werden 49 m² an Aluminiumplättchen gewonnen. Die gewählte Aufdampfdicke beträgt je nach der Verwendung des Produktes 50 bis 500 Nanometer.

### Beispiel II:

In der im Beispiel I verwendeten Vakuumkammer wird die Drehachse des scheibenförmigen Trägers von 1,90 Meter Durchmesser vertikal eingebaut. Nach Fig. 3 befinden sich ein Trennmittelverdampfer mit wasserfreiem Natriumchlorid und drei Elektronenstrahlverdampfer unterhalb der Scheibe am Umfang. Alle Verdampfer sind auf demselben Radius des Trägers angeordnet. In zum Beispiel I abgewandelter Form wird auf dem horizontalen Träger nacheinander eine Schicht aus Natriumchlorid-Aluminiumoxid-Titan-Aluminiumoxid bei einem Vakuum von 7 x 10-5 mbar aufgedampft, wobei den Verdampfern alle Materialien kontinuierlich oder diskontinuierlich zugeführt werden. Entsprechende Einrichtungen sind aus der Literatur bekannt. Die auf dem Rotationsweg folgende Ablösestation unterscheidet sich dadurch, daß das Gefäß, in welchem die Ablösung der Schichten erfolgt, mit seinem Rand sehr eng, aber ohne diesen zu berühren, an der Unterseite der rotierenden Scheibe anliegt. Das Vakuum im Raum über dem Flüssigkeitspegel und dem scheibenförmigen Träger beträgt 0.04mbar. Rotierende Bürsten aus vakuumtechnisch geeignetem Material befördern die Flüssigkeit, in diesem Fall Ethylenglykol von 30°C, an den Träger und lösen das Trennmittel auf. Die aus 3 Schichten bestehenden Produktschichten suspendieren sich als Flocken in der Flüssigkeit. Ein Tauchverfahren ist wegen der horizontalen Anordnung der Scheibe hier nicht möglich. Der Träger rotiert mit einer Geschwindigkeit von 5 Umdrehungen pro Minute. Das erhaltene Produkt weist eine Dicke von 150 Nanometer auf. Die Plättchen werden auf gleiche Weise wie im Beispiel I erläutert, gewonnen.

### Beispiel III:

In derselben Anordnung des Trägers, der Verdampfer und der Ablösestation des Beispiels I sollen planparallele Plättchen einer gewissen Zahl von sich wiederholenden Schichten des Typs A,B oder A,B,C erzeugt werden. Das in diesem Beispiel aufgedampfte Schichtsystem besteht aus einer Trennmittelschicht, hier Calciumchlorid, und einer Schichtenfolge aus Titanoxid und Magnesiumfluorid, welche 15-mal wiederholt wird und mit einer weiteren Titanoxid endet. Der wesentliche Unterschied zu den Beispielen I und II ist, daß die Aufdampfung der Schichten nach folgender Reihenfolge durchgeführt wird:
- Die das Produkt vom Träger ablösenden Bürsten werden soweit abgesenkt, daß sie nicht mehr im Kontakt mit dem Träger stehen.
- Der Trennmittelverdampfer trägt während ein bis zwei vollen Umdrehungen des Trägers Calciumchlorid auf. Danach wird eine Blende zwischen ihn und dem Träger nach bekannter Weise eingefahren. Weiteres Trennmittel erreicht den Träger nicht mehr.
- Je ein Verdampfer, mit Titanoxid und Magnesiumfluorid gefüllt, trägt in kontrollierter Schichtdicke pro Umdrehung, bei gleichzeitiger Messung der aufgetragenen Schichtdicke nach bekannten Verfahren eine hochbrechende und eine niedrigbrechende Schicht auf. Nach Erreichen der gewünschten Schichtzahl werden beide Verdampfer mit einer Blende verschlossen.
- Die rotierenden Bürsten, die die Aufgabe haben, das Schichtsystem mittels einer Flüssigkeit, hier mittels Ethylenglykol, durch Auflösen des aufgedampften Trennmittels von Träger zu entfernen, werden mechanisch so verstellt, daß sie in Berührung mit dem Träger gelangen. Die Ablösung und Weiterverarbeitung der Plättchen geschieht in der im Beispiel I beschriebenen Weise. Die Rotationsgeschwindigkeit des Trägers wird so weit reduziert, daß die Ablösung in einem einzigen Durchgang erfolgen kann.
- Die rotierenden Bürsten werden wieder so verstellt, daß sie nicht in Kontakt mit dem rotierenden Träger gelangen.
- Es beginnt die Wiederholung des Prozesses.

Vorteilhaft ist es, daß mit dieser Variante nach Beispiel III mit wenigen Verdampfern planparallele Plättchen mit einer großen Zahl von sich wiederholenden Schichtpaaren oder Dreifachschichten ohne Unterbrechung des Vakuums erzeugt werden können.

In den Beispielen I bis III gelangen noch sehr geringe Spuren der Ablöseflüssigkeit als ein an dem Träger anhaftender Film von wenigen Moleküllagen in den Verdampfungsteil. Dieser Effekt, der bei allen anderen Verfahren der Vakuumbeschichtung sehr schädlich wäre, erweist sich hier in den meisten Anwendungsfällen sogar als nützlich, da er die Haftfestigkeit des aufgedampften Trennmittels auf dem Träger vermindert und für eine schnellere und vollkommende Ablösung in der Flüssigkeit sorgt. Da die Aufdampfschichten selbst das Produkt bilden, ist eine gute Haftung an einer Oberfläche nicht gefordert.

Alle Varianten erfüllen den Erfindungsgedanken, der darauf basiert, daß auf ein oder mehrere in einer Vakuumkammer mit 2 oder 3 Vakuumzonen rotierenden starren Träger nacheinander ein Trennmittel und die Produktschichten bei einer Umdrehung von 360° des Trägers, der ein rotationssymmetrisches Gebilde ist, im Vakuum aufgebracht werden. Diese Produktschichten werden gleichzeitig an einer anderen Stelle vom Träger abgelöst und die dadurch erhaltene Suspension wird aus dem Vakuumraum entfernt. Danach erfolgt durch Filtern, Zentrifugieren, weiteres Verkleinern und Einbringen in einen flüssigen Träger, der ein Lack oder eine Tinte sein kann, die weitere Verarbeitung der Suspension bei Atmosphärendruck zu den Endprodukten, wie metallisch reflektierenden Lacken oder Druckfarben.

Ein kontinuierliches, mittels eines Vakuum-Beschichtungsverfahrens auf einem oder mehreren beweglichen rotationssymmetrischen, starren Trägern erzeugtes Schichtsystem weist somit eine oder mehrere anorganische Trennmittelschichten und darauf abgeschiedene Produktschichten aus Metallen, Oxiden, Fluoriden, Nitriden oder Karbiden, welche in einem einzigen Umlauf kontinuierlich vom Träger durch Einwirken einer Flüssigkeit entfernt werden, welche die anorganische Trennmittelschicht löst und gleichzeitig die nicht in der Flüssigkeit löslichen Produktschichten vom Träger ablöst und in Flocken zerfallen läßt, auf. Ein um eine Achse rotierender, starrer Träger befindet sich dabei in einer Vakuumkammer, die in mindestens zwei Druckstufen durch Zwischenabschottungen geteilt ist, wobei der Bereich, in welchem der rotierende, starre Träger die Zwischenabschottungen durchquert, als Kanal ausgebildet ist. Der rotierende, starre Träger wird in einer ersten Zone mit einem in einer Flüssigkeit löslichen, im Vakuum ohne Zersetzung verdampfbaren Trennmittel beschichtet und durchläuft während derselben Rotation eine zweite Zone mit einem oder mehreren Verdampfern, welche die Produktschichten erzeugen. Der starre Träger durchläuft auf seinem Rotationsweg eine dritte Zone in einen getrennt gepumpten weiteren Vakuumraum von 10-3 bis 1 mbar, in welchem die Trennmittelschicht oder die Trennmittelschichten mittels einer Flüssigkeit, deren Dampfdruck geringer oder gleich dem Druck im zweiten Vakuumraum ist, aufgelöst wird, wobei sich die nicht lösliche Produktschicht oder die Produktschichten als nicht zusammenhängende Teilchen vom Träger ablösen und dann als Suspension in der Flüssigkeit vorliegen. Der rotierende, starre Träger wird auf seinem weiteren Rotationsweg der Einwirkung der Flüssigkeit entzogen, von Resten der Flüssigkeit befreit, dem Prozeß der Beschichtung mit Trennmittel und den Produktschichten wieder zugeführt.

Die Schritte der Bedampfung mit Trennmittel und mit den Produktschichten und die Auflösung des Trennmittels in einer Flüssigkeit erfolgen bei gleicher Winkelgeschwindigkeit des starren, rotierenden Trägers kontinuierlich und gleichzeitig an verschiedenen Orten des Trägers.

Durch sich wiederholende Anordnung eines Verdampfers für das Trennmittel und der Verdampfer für die Produktschichten können mehrere Lagen von Produktschichten während derselben Rotation des starren Trägers gleichzeitig erzeugt werden.

Der rotierende, starre Träger kann aus einer oder mehreren parallelen Scheiben, einem oder mehreren geschlossenen oder offenen Zylindern oder aus einem oder mehreren geschlossenen oder offenen, anderen rotations- symmetrischen Körpern bestehen, die entweder auf einer gemeinsamen Achse oder auf mehreren Achsen rotieren.

Bei Verwendung eines rotierenden, starren Trägers, der aus mehreren parallelen Scheiben besteht, können alle oder einige gleichzeitig beidseitig beschichtet werden.

Neben dem Aufdampfverfahren können auch weitere Beschichtungsverfahren unter Vakuum, wie das Sputtern oder die Plasmapolymerisation, oder eine Kombination dieser Verfahren in derselben Vakuumkammer verwendet werden.

Der rotierende, starre Träger weist eine Oberfläche auf, die aus Metall, Glas, Email, einer Keramik oder einem organischen Material besteht, wobei das Material der Oberfläche und des Trägers unterschiedlich sein kann.

Der rotierende starre Träger weist eine Oberfläche auf, die entweder naturbelassen, poliert oder strukturiert sein kann.

Die Schritte der Beschichtung mit Trennmittel, die sich mindestens einmal wiederholende Beschichtung mit mindestens zwei verschiedenen Substanzen, welche in ihrer Gesamtheit eine Schichtsystem ergeben, und die Ablösung dieses Schichtsystems erfolgen nacheinander und ohne Unterbrechung des Vakuums.

Als Alternative zur Beschichtung mit einem anorganischen Trennmittel kann mit einem organischen Trennmittel beschichtet werden. Somit besteht statt des Lösens des Trennmittels in einem Lösungsmittel die Möglichkeit ein organisches Trennmittel wie z.B. Wachs, Harz oder ein thermoplastischer Kunststoff beispielsweise durch Verdampfung oder im flüssigen Zustand durch Tauchen, Walzen, Gießen oder Sprühen auf den Träger, aufzutragen. Beispiele für das organische Trennmittel sind Natrium-, Lithium-, Magnesium-, Aluminiumstearat, Fettalkohole und Wachsalkohole des Typs CₓH_{y}O mit 15 < C < 30, Paraffinwachse, verzweigte und unverzweigte Fettsäuren mit C > 15 und Thermoplaste.

Auf das auf diese Weise aufgebrachte organische Trennmittel kann in gleicher Weise wie beim anorganischen Trennmittel die zumindest eine Produktschicht aufgedampft werden.

Die Wahl organischer Trennmittel erfolgt nach vier Kriterien:
- Das Trennmittel muß bei der vorkommenden thermischen Belastung des Trägers durch das Aufdampfen der Produktschicht noch als fester Körper vorliegen.
- Das Trennmittel darf sich im flüssigen geschmolzenen Zustand unter Vakuum nur in sehr geringem Maße zersetzen und soll am Schmelzpunkt einen möglichst geringen Dampfdruck aufweisen, vorzugsweise von weniger als 1 mbar.
- Es darf mit der darauf aufgedampften Produktschicht keine chemische Reaktion eingehen.
- Das verwendete Trennmittel muß bei der nachfolgenden Weiterverarbeitung der Pigmente in Lacken oder Druckfarben mit bekannten Verfahren leicht abtrennbar sein oder im Endprodukt erlaubt sein.

Bei der weiteren Drehung des Trägers taucht dieser in ein Bad mit demselben geschmolzenen organischen Stoff wie das Trennmittel ein. Dort zerfällt die Produktschicht beim Schmelzen des organischen Stoffes in kleine Partikel, die dann als Suspension oder Sediment in dem organischen Stoff vorliegen. In den weiteren Schritten kann diese Suspension auf gleiche Art und Weise abgepumpt, gefiltert und der weiteren Verarbeitung zu Lacken oder Druckfarben zugeführt werden.

Ein Vorteil der Verwendung eines solchen Verfahrens mit einem organischen Trennmittel besteht darin, daß nach dem Austauchen aus dem Bad eine dünne Schicht des organischen Stoffes auf dem Träger verbleibt, welche dann erneut als Trennmittel zum Einsatz gelangt. Eventuell in diese Trennmittelschicht noch eingebettete, wenige Pigmentpartikel spielen keine Rolle und laufen nochmals durch den Prozeß, ohne daß sie weiter bedampft werden, da diese in dem Trennmittel eingebettet sind.

Die vorliegende Erfindung bezieht sich somit auf eine Vorrichtung zum Erzeugen von planparallen Plättchen mit einem um eine Achse drehbaren Träger, einer Einrichtung zur Beschichtung eines Flächenabschnitts des Trägers mit zumindest einer Produktschicht, einer Einrichtung zum Ablösen der Produktschicht von dem Flächenabschnitt des Trägers in einer solchen Weise, daß planparallele Plättchen entstehen, wobei der Transport des Flächenabschnitts zwischen der Beschichtungseinrichtung und der Ablöseeinrichtung durch Rotation des Trägers erfolgt. Dabei kann eine Einrichtung zum Beschichten des Trägers mit einer Trennmittelschicht vor dem Aufbringen der Produktschicht vorgesehen sein. In der Ablöseeinrichtung wird die Trennmittelschicht aufgelöst und werden die planparallelen Plättchen freigesetzt.

## Patentansprüche

1. Verfahren zum Erzeugen von planparallelen Plättchen, das die Schritte aufweist:
a) Beschichten eines Flächenabschnitts eines um eine Achse drehbaren, in einer Vakuumkammer befindlichen, starren Trägers (5) mit einem Trennmittel und anschließend mit zumindest einer Produktschicht,
b) Transport des Flächenabschnitts durch Rotation des Trägers (5) im Anschluß an Schritt a),
c) Ablösen der Produktschicht von dem Flächenabschnitt des in der Vakuumkammer befindlichen Trägers im Anschluß an Schritt b) durch Auflösung oder Schmelzen der Trennmittelschicht in einer solchen Weise, daß planparallele Plättchen entstehen.

2. Verfahren nach Anspruch 1, wobei in Schritt a) mit einem anorganischen Trennmittel, welches sich im Vakuum ohne Dissoziation verdampfen läßt, beschichtet wird.

3. Verfahren nach Anspruch 1 oder 2, wobei in Schritt a) zumindest zwei Produktschichten auf den Flächenabschnitt des Trägers (5) aufgebracht werden.

4. Verfahren nach einem der Ansprüche 1 bis 3, wobei die Schritte a) bis c) während einer Umdrehung des Trägers (5) ausgeführt werden.

5. Verfahren nach einem der Ansprüche 1 bis 3, wobei die Schritte a) und b) während zumindest zwei Umdrehungen des Trägers (5) ausgeführt werden und sich Schritt c) anschließt.

6. Verfahren nach einem der vorhergehenden Ansprüche, wobei die Schritte a), b) und c) bei gleicher Winkelgeschwindigkeit des Trägers kontinuierlich und gleichzeitig an verschiedenen Flächenabschnitten des Trägers ausgeführt werden.

7. Verfahren nach Anspruch 1, wobei der Flächenabschnitt des Trägers (5) in Schritt a) vor dem Aufbringen der Produktschicht mit einem organischen Trennmittel beschichtet wird und in Schritt c) die Trennmittelschicht geschmolzen wird.

8. Verfahren nach Anspruch 7, wobei der Flächenabschnitt des Trägers (5) in Schritt a) durch Tauchen, Walzen, Gießen oder Sprühen flüssig beschichtet wird, im weiteren Verlauf der rotierenden Bewegung des Trägers (5) die Trennmittelschicht durch Abkühlung des Trägers auf diesem erstarrt, in der Folge mit einer oder mehreren Produktschichten im Hochvakuum bedampft wird und danach in Schritt c) die Trennmittelschicht geschmolzen wird, wobei die sich auf dieser befindlichen Produktschicht in Flocken zerfällt und dann im Trennmittel als Gemisch vorliegt.

9. Verfahren nach einem der vorhergehenden Ansprüche, wobei
die Produktschichten Metalle, -Oxide, Fluoride oder Karbide aufweisen, und
der Träger (5) Metall, Glas, Email, Keramik oder ein organisches Material aufweist.

10. Vorrichtung zum Erzeugen von planparallelen Plättchen, insbesondere zur Ausführung des Verfahrens nach einem der vorhergehenden Ansprüche, mit
einem um eine Achse drehbaren, in einer Vakuumkammer befindlichen, starren Träger (5),
einer Einrichtung (9a, 9b, 9c) zur Beschichtung eines Flächenabschnitts des Trägers (5) mit zumindest einer Produktschicht,
einer Einrichtung zum Beschichten des Trägers mit einer Trennmittelschicht vor dem Aufbringen der Produktschicht,
einer Einrichtung (13) zum Ablösen der Produktschicht von dem Flächenabschnitt des Trägers durch Auflösung oder Schmelzen der Trennmittelschicht in einer solchen Weise, daß planparallele Plättchen entstehen,
wobei der Transport des Flächenabschnitts zwischen der Beschichtungseinrichtung (9a, 9b, 9c) und der Ablöseeinrichtung (13) durch Rotation des Trägers (5) erfolgt.

11. Vorrichtung nach Anspruch 10, wobei sich der Träger (5) in einer Vakuumkammer befindet und zwischen der Einrichtung zur Beschichtung mit der Produktschicht und der Ablöseeinrichtung (13) eine Zwischenabschottung (12a, 12b) zur Erzeugung von zwei Druckstufen vorgesehen ist.

12. Vorrichtung nach Anspruch 10 oder 11, wobei der Träger (5) einen offenen oder geschlossenen rotationssymmetrischen starren Körper aufweist.

13. Vorrichtung nach einem der-Ansprüche 10 bis 11, wobei der Träger (5) mehrere offene oder geschlossene rotationssymmetrische starre Körper aufweist, die um eine gemeinsame Achse oder um mehrere Achsen rotieren.

14. Vorrichtung nach Anspruch 13, wobei der Träger (5) mehrere parallele Scheiben aufweist, von denen zumindest eine von der Beschichtungseinrichtung beidseitig beschichtbar ist.

## Claims

1. A process for producing plane-parallel platelets, comprising the steps of:
a) coating a partial surface of a rigid carrier rotatable about an axis (5) and located in a vacuum chamber with a separating agent and subsequently with at least one product layer,
b) transporting said partial surface through rotation of said carrier (5) subsequently to step a),
c) stripping said product layer from said partial surface of said carrier located in said vacuum chamber subsequently to step b) through dissolving or melting said separating agent layer, in such a way that plane-parallel platelets are produced.

2. The process according to claim 1, wherein coating in step a) is carried out with an inorganic separating agent which may be evaporated in vacuum without dissociation.

3. The process according to claim 1 or 2, wherein in step a) at least two product layers are applied on said partial surface of said carrier (5).

4. The process according to any one of claims 1 to 3, wherein steps a) to c) are performed during one rotation of said carrier (5).

5. The process according to any one of claims 1 to 3, wherein steps a) and b) are performed during at least two rotations of said carrier (5) and are followed by step c).

6. The process according to any one of the preceding claims, wherein steps a), b) and c) are performed continuously and simultaneously on different partial surfaces of said carrier at a same angular velocity of said carrier.

7. The process according to claim 1, wherein said partial surface of said carrier (5) is coated with an organic separating agent in step a) prior to application of said product layer, and said separating agent layer is melted in step c).

8. The process according to claim 7, wherein in step a) said partial surface of said carrier (5) is liquid-coated by dipping, rolling, pouring or spraying, in the further course of the rotating movement of said carrier (5) said separating agent layer solidifies on said carrier through cooling of said carrier, is subsequently vapor deposition coated with one or several product layers in high vacuum, and afterwards in step c) said separating agent layer is melted, wherein said product layer located thereon falls apart into flakes, to then be present as a mixture in said separating agent.

9. The process according to any one of the preceding claims, wherein
said product layers include metals, oxides, fluorides or carbides, and
said carrier (5) comprises metal, glass, enamel, ceramic, or an organic material.

10. Apparatus for producing plane-parallel platelets, in particular for implementing the process according to any one of the preceding claims, comprising
a rigid carrier (5) rotatable about an axis and located in a vacuum chamber,
means (9a, 9b, 9c) for coating a partial surface of said carrier (5) with at least one product layer,
means for coating said carrier with a separating agent layer prior to application of said product layer,
means (13) for stripping said product layer from said partial surface of said carrier by dissolving or melting said separating agent layer in such a way that plane-parallel platelets are produced,
with transport of said partial surface between said coating means (9a, 9b, 9c) and said stripping means (13) being effected through rotation of said carrier (5).

11. Apparatus according to claim 10, wherein said carrier (5) is located in a vacuum chamber, and an intermediate separation (12a, 12b) for creating two pressure stages is provided between said means for coating with said product layer and said stripping means (13).

12. Apparatus according to claim 10 or 11, wherein said carrier (5) comprises an open or closed, rotationally symmetrical, rigid body.

13. The apparatus according to any one of claims 10 to 11, wherein said carrier (5) comprises several open or closed, rotationally symmetrical, rigid bodies which rotate about a common axis or about several axes.

14. The apparatus according to claim 13, wherein said carrier (5) comprises several parallel discs of which at least one may be coated face-and-back by said coating means.

## Revendications

1. Procédé pour la production de plaquettes à faces planes et parallèles, comportant les étapes suivantes :
a) un élément plat d'un support rigide (5) pivotant autour d'un axe et situé dans une chambre à vide, est recouvert au moins d'un isolant et d'une couche de produit au moins ;
b) à la fin de la phase a), l'élément plat est transporté par rotation du support (5) ;
c) à la fin de la phase b), la couche de produit est éliminée de l'élément plat du support qui se trouve dans la chambre à vide par dissolution ou par fusion de la couche isolante, de manière à produire des plaquettes à faces planes et parallèles.

2. Procédé selon la revendication 1, **caractérisé en ce qu'**une enduction est réalisée avec un isolant inorganique pouvant s'évaporer sous vide sans dissociation durant la phase a).

3. Procédé selon la revendication 1 ou 2, **caractérisé en ce que** deux couches de produit au moins sont appliquées sur l'élément plat du support (5) durant la phase a).

4. Procédé selon l'une quelconque des revendications 1 à 3, **caractérisé en ce que** les phases a) à c) sont exécutées durant une rotation du support (5).

5. Procédé selon l'une quelconque des revendications 1 à 3, **caractérisé en ce que** les phases a) et b) sont exécutées au cours de deux rotations au moins du support (5), et que la phase c) leur succède.

6. Procédé selon l'une quelconque des revendications précédentes, **caractérisé en ce que** les phases a), b) et c) sont exécutées en continu et simultanément sur plusieurs éléments plats du support, à une vitesse angulaire identique du support.

7. Procédé selon la revendication 1, **caractérisé en ce que** l'élément plat du support (5) est recouvert avec un isolant organique au cours de la phase a), avant l'application de la couche de produit, et que cette couche isolante est fondue au cours de la phase c).

8. Procédé selon la revendication 7, **caractérisé en ce que** l'élément plat du support (5), au cours de la phase a), est recouvert d'un liquide par immersion, par léchage, par coulée ou par pulvérisation, la couche isolante étant alors solidifiée par refroidissement du support pendant la rotation, avant de recevoir une ou plusieurs couches de produit, qui sont appliquées par vaporisation sous vide poussé, la couche isolante étant ensuite fondue au cours de la phase c) et la couche de produit sur l'isolant se désagrégeant pour se mêler à l'isolant.

9. Procédé selon l'une quelconque des revendications précédentes **caractérisé en ce que**
- les couches de produit sont constitués de métaux ; oxyde, fluorure ou carbure, et
- le support (5) présente du métal, du verre, de l'émail, de la céramique ou une substance organique.

10. Dispositif pour la production de plaquettes à faces planes et parallèles, notamment pour l'exécution du procédé selon l'une quelconque des revendications précédentes, comprenant
- un support rigide (5) pivotant autour d'un axe et situé dans une chambre à vide ;
- un dispositif (9a, 9b, 9c) pour recouvrir un élément plat du support (5) avec au moins une couche de produit;
- un dispositif pour recouvrir le support d'une couche isolante préalablement à l'application de la couche de produit ;
- un dispositif (13) pour éliminer la couche de produit de l'élément plat du support par dissolution ou par fusion de la couche isolante, de manière à produire des plaquettes à faces planes et parallèles ;
- dans lequel le déplacement de l'élément plat entre le dispositif d'enduction (9a, 9b, 9c) et le dispositif d'élimination (13) est réalisé par rotation du support (5).

11. Procédé selon la revendication 10, **caractérisé en ce que** le support (5) se trouve dans une chambre à vide et qu'une cloison intermédiaire (12a, 12b) est prévue entre le dispositif d'enduction avec le produit et le dispositif d'élimination (13) de manière à générer deux niveaux de pression.

12. Dispositif selon la revendication 10 ou 11, **caractérisé en ce que** le support (5) présente un corps rigide symétrique rotatif pouvant être ouvert ou fermé.

13. Dispositif selon l'une quelconque des revendications 10 à 11, **caractérisé en ce que** le support (5) présente plusieurs corps rigides symétriques rotatifs pouvant être ouverts ou fermés et pivotant autour d'un axe commun ou de plusieurs axes.

14. Dispositif selon la revendication 13, **caractérisé en ce que** le support (5) présente plusieurs disques parallèles, dont l'un au moins peut être recouvert des deux côtés à l'aide du dispositif d'enduction.
